# FASCICULE DE BREVET EUROPEEN

(11) **EP 1 902 469 B1**
(45) Date de publication et mention de la délivrance du brevet: **16.03.2016**
(21) Numéro de dépôt: 06778994.1
(22) Date de dépôt: 29.06.2006
(51) Int. Cl.: H01L 27/12, H01L 21/77

(54) **PROCÉDÉ DE FABRICATION DE LA PLAQUE ACTIVE D'UN ÉCRAN PLAT**
VERFAHREN ZUR HERSTELLUNG EINER FLACHBILDSCHIRMANZEIGE-AKTIVPLATTE
METHOD FOR MANUFACTURING THE ACTIVE PLATE OF A FLAT-PANEL DISPLAY

(30) Priorité: 30.06.2005 FR 0551839
(43) Date de publication de la demande: 26.03.2008
(73) Titulaire: Centre National de la Recherche Scientifique, 75794 Paris Cedex 16 (FR); Ecole Polytechnique, 91128 Palaiseau Cedex (FR)
(72) Inventeur: PRIBAT, Didier, F-92310 Sevres (FR); COJOCARU, Costel Sorin, F-91120 Palaiseau (FR)
(74) Mandataire: Thibon, Laurent
(86) Numéro de dépôt international: PCT/FR2006/050650
(87) Numéro de publication internationale: WO 2007/003852

(56) Documents cités:
- FR-A- 2 860 780
- US-A1- 2004 017 520
- LEW K-K ET AL: "Growth characteristics of silicon nanowires synthesized by vapor-liquid-solid growth in nanoporous alumina templates" JOURNAL OF CRYSTAL GROWTH, ELSEVIER, AMSTERDAM, NL, vol. 254, no. 1-2, juin 2003 (2003-06), pages 14-22, XP004424628 ISSN: 0022-0248
- PRIBAT D. COJOCARU C. ET AL.: "Lateral alumina templates for carbon nanotubes and semiconductor nanowires synthesis" PROCEEDINGS OF THE SPIE - QUANTUM SENSING AND NANOPHOTONIC DEVICES II, vol. 5732, 23 janvier 2005 (2005-01-23), - 27 janvier 2005 (2005-01-27) pages 58-67, XP008061007 San Jose, USA
- REDWING J. M., LEW K.K. ET AL.: "Synthesis and properties of Si and SiGe/Si nanowires" PROCEEDINGS OF THE SPIE - QUANTUM DOTS, NANOPARTICLES, AND NANOCLUSTERS, vol. 5361, 26 janvier 2004 (2004-01-26), - 27 janvier 2004 (2004-01-27) pages 52-59, XP002370489 San Jose, USA

## Description

### DOMAINE DE L'INVENTION

La présente invention concerne le domaine de la fabrication des écrans plats. Elle concerne également une structure de transistor particulièrement adaptée à la fabrication de tels écrans.

La présente invention s'applique notamment à des écrans matriciels tels que les écrans à cristaux liquides (LCD) et les écrans à diodes organiques électroluminescentes couramment désignées par le sigle OLED. Ces écrans plats nécessitent la réalisation d'une plaque dite plaque active portant une matrice de pixels comportant des transistors sur une plaque isolante de grande surface. Les écrans LCD comprennent généralement un transistor par cellule et les écrans OLED au moins deux transistors par cellule.

### EXPOSE DE L'ART ANTERIEUR

La plaque inférieure ou plaque active d'un écran plat matriciel tel qu'un écran LCD est généralement réalisée à partir d'une plaque de verre ou autre matériau isolant, de préférence transparent, de très grandes dimensions. Dans les techniques de fabrication actuelles, on utilise couramment des plaques de verre dont l'un ou les deux côtés ont des dimensions supérieures au mètre, ou bien pour former de très grands écrans ou bien pour former des écrans de dimensions souhaitées par découpe des plaques après fabrication. Chaque plaque inférieure est mise en regard d'une plaque supérieure dont elle est séparée par des espaceurs. L'espace entre les plaques inférieure et supérieure est rempli d'un cristal liquide dont les propriétés optiques dépendent de la polarisation de chaque pixel de l'écran.

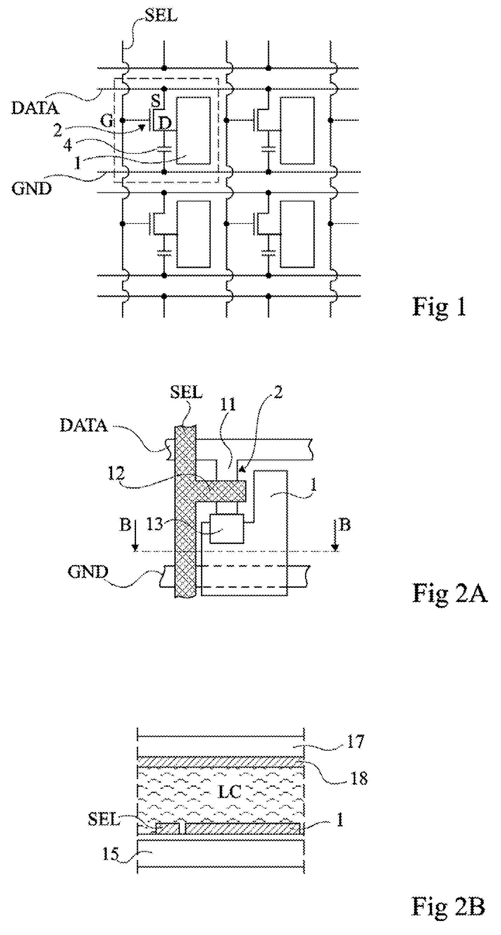

La figure 1 représente partiellement sous forme de circuit l'allure d'un ensemble de quatre pixels de la plaque active d'un écran de type LCD. Chaque pixel comprend une plaque d'électrode 1 qui peut être mise à un potentiel haut ou bas par sa connexion à une ligne de données (DATA) réalisée par l'intermédiaire d'un commutateur 2, couramment un transistor MOS, dont la grille est reliée à une ligne de sélection (SEL). La plaque d'électrode 1 est destinée à constituer une première armature d'un condensateur dont l'autre armature est formée sur l'autre plaque (plaque supérieure) de l'écran. Dans l'exemple de la figure 1, les lignes de données DATA correspondent à des rangées et les lignes de sélection SEL correspondent à des colonnes. On a désigné par G, S et D les bornes de grille, de source et de drain du transistor MOS 2, étant entendu que les appellations source et drain peuvent éventuellement être interchangées. Dans l'exemple de la figure 1, la borne de drain est également connectée à une capacité 4 dont la deuxième borne est reliée à un potentiel fixe, par exemple une ligne de masse GND.

L'une des difficultés de réalisation de la plaque active d'un écran LCD réside dans la réalisation du commutateur 2. Comme on l'a indiqué, ce commutateur est généralement réalisé sous forme d'un transistor MOS. Toutefois, étant donné les coûts que cela impliquerait, il n'est pas question de rapporter une puce de transistor au niveau de chaque cellule.

On a donc cherché à fabriquer des transistors à partir de couches semiconductrices déposées directement sur la plaque de verre de base ou sur une couche intermédiaire déposée sur cette plaque.

Les deux techniques principales développées à ce jour pour la réalisation de tels transistors en couches minces (couramment désignés par le sigle TFT, de l'anglais : Thin Film Transistors) sont basées sur des dépôts de silicium amorphe hydrogéné et sur des dépôts de silicium polycristallin.

Les transistors réalisés à partir d'un dépôt de silicium amorphe hydrogéné sont les plus simples à réaliser et permettent de limiter le nombre d'étapes de masquage impliquées dans la réalisation de la plaque active. Ils présentent toutefois de nombreux inconvénients liés à la faible mobilité des porteurs, ce qui limite leur rapidité et leur capacité à transporter du courant. De plus, le silicium amorphe hydrogéné est un matériau métastable qui présente des dérives importantes en ce qui concerne la tension de seuil des transistors lorsque ceux-ci sont sollicités avec un rapport cyclique élevé.

On a tenté de réaliser des transistors à partir de silicium polycristallin obtenu par cristallisation d'un précurseur amorphe. Toutefois, cette technologie n'est pas encore très développée et présente de grandes difficultés de réalisation et des performances imparfaites notamment en comparaison des transistors réalisés sur substrat monocristallin.

### RESUME DE L'INVENTION

Un objet de la présente invention est de réaliser une plaque active d'écran plat dans laquelle chaque cellule comprend au moins une plaque d'électrode et un transistor, les diverses cellules étant associées de façon matricielle.

Un autre objet de la présente invention est de réaliser une telle structure dans laquelle les transistors présentent de bonnes caractéristiques électriques.

Un autre objet de la présente invention est de prévoir une telle plaque qui puisse être fabriquée en un nombre réduit d'étapes et notamment d'étapes de masquage.

Un objet plus général de la présente invention est de prévoir un transistor à effet de champ réalisable sur une plaque isolante.

Pour atteindre ces objets, la présente invention prévoit un procédé de fabrication de la plaque active d'un écran plat matriciel, dans lequel chaque cellule comprend une plaque d'électrode connectée par un transistor à une première ligne conductrice, comprenant les étapes suivantes :
prévoir une excroissance enrobée d'isolant de chaque première ligne conductrice au niveau de chaque cellule ;
graver ou rendre poreuse une partie d'extrémité de chaque excroissance ;
faire croître latéralement, par un procédé dit VLS (vapeur-liquide-solide), une structure semiconductrice PIP ou NIN dans chaque partie d'extrémité gravée ou rendue poreuse ; et
établir un contact à l'extrémité libre de la structure semiconductrice et former une grille au niveau de la partie médiane de la structure semiconductrice.

Selon un mode de réalisation de la présente invention, le métal des premières lignes conductrices est de l'aluminium qui est rendu poreux par oxydation anodique au niveau desdites excroissances.

Selon un mode de réalisation de la présente invention, le métal des premières lignes conductrices est du nickel, du molybdène ou du cuivre qui est éliminé partiellement sous la partie isolée.

Selon un mode de réalisation de la présente invention, le procédé comprend les étapes suivantes :
déposer et graver sur une plaque de verre une première couche conductrice pour définir les premières lignes conductrices comprenant des excroissances au niveau de chaque cellule ;
revêtir la structure d'une couche d'un matériau isolant ;
ouvrir l'extrémité des excroissances et former des transistors dans celles-ci ;
déposer et graver une deuxième couche conductrice pour former les plaques d'électrode ; et
déposer et graver une troisième couche conductrice pour définir des deuxièmes lignes conductrices, ces deuxièmes lignes comportant des portions recouvrant les zones de canal des transistors, et pour définir une région conductrice connectant une borne principale d'un transistor à une plaque d'électrode.

Selon un mode de réalisation de la présente invention, lors de l'étape de définition des plaques d'électrodes, on prévoit en outre le maintien de régions conductrices au-dessus de parties où les deuxièmes lignes sont amenées à croiser d'autres lignes ou métallisations de la structure.

Selon un mode de réalisation de la présente invention, le procédé comprend les étapes suivantes :
définir dans une première couche conductrice des premières lignes comprenant des excroissances au niveau de chaque cellule, et des portions de deuxièmes lignes aux emplacements où elles ne croisent pas des premières lignes ;
dégager l'extrémité des premières excroissances et la surface supérieure desdites portions ;
former des transistors dans les excroissances ;
déposer une deuxième couche conductrice, cette deuxième couche étant gravée pour former :
   - la plaque d'électrode de chaque cellule,
   - une région de grille en contact avec lesdites portions, et
   - des régions reliant entre elles les portions pour assurer la continuité des deuxièmes lignes.

Selon un mode de réalisation de la présente invention, une partie de la plaque d'électrode s'étend au-dessus d'une portion d'une troisième ligne conductrice, la ligne conductrice étant une ligne d'aluminium et un diélectrique tel que de l'alumine étant interposé entre la partie de plaque d'électrode et la ligne conductrice.

Selon un mode de réalisation de la présente invention, deux transistors par cellule sont formés simultanément à partir d'excroissances enrobées d'isolant de diverses lignes conductrices de chaque cellule.

### BREVE DESCRIPTION DES DESSINS

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente partiellement sous forme de circuit l'allure d'une cellule de la plaque active d'un écran plat matriciel tel qu'un écran LCD ;
la figure 2A est une vue de dessus de la partie de plaque active d'une cellule d'un écran plat de type LCD selon un mode de réalisation de la présente invention ;
la figure 2B est une vue en coupe simplifiée d'une portion d'un écran plat de type LCD comprenant une plaque active selon la présente invention ;
les figures 3A à 3D sont des vues de dessus illustrant des étapes successives de fabrication d'une cellule d'écran plat selon un premier mode de réalisation de la présente invention ;
les figures 4A à 4D sont des vues en coupe illustrant des étapes successives de réalisation d'un transistor selon un aspect de la présente invention ;
les figures 5A à 5D sont des vues en coupe illustrant des étapes successives de réalisation d'un transistor selon un autre aspect de la présente invention ;
la figure 6 est une vue de dessus illustrant une variante d'une étape de fabrication d'une cellule d'écran plat selon le premier mode de réalisation de la présente invention ;
les figures 7A et 7B sont des vues de dessus illustrant des étapes successives de fabrication d'une cellule d'écran plat selon un deuxième mode de réalisation de la présente invention ;
la figure 8 représente partiellement sous forme de circuit l'allure d'une cellule de la plaque active d'un écran plat matriciel tel qu'un écran OLED ;
la figure 9A est une vue de dessus de la partie de plaque active d'une cellule d'un écran plat de type OLED selon un mode de réalisation de la présente invention ; et
la figure 9B est une vue en coupe simplifiée d'une portion d'un écran plat de type OLED comprenant une plaque active selon la présente invention.

Par souci de clarté, de mêmes éléments ont été désignés par de mêmes références dans les différentes figures. De plus, comme cela est habituel dans la représentation des circuits intégrés, les diverses figures ne sont pas tracées à l'échelle.

### DESCRIPTION DETAILLEE

### Première réalisation d'une cellule de plaque active d'écran LCD

La figure 2A représente un mode de réalisation d'une cellule de plaque active d'écran plat de type LCD selon la présente invention. Cette cellule est formée au croisement d'une rangée de données DATA et d'une colonne de sélection SEL toutes deux constituées de bandes conductrices. La plaque d'électrode est réalisée sous forme d'une plaque conductrice 1, par exemple en un matériau conducteur transparent tel que de l'ITO (oxyde d'indium et d'étain). Le transistor 2 est formé dans une excroissance 11 de la ligne de données DATA d'une façon qui sera exposée plus en détail ci-après. La grille G du transistor 2 est constituée d'une portion 12 de la ligne de sélection SEL s'étendant au-dessus de la partie médiane de l'excroissance 11. Un plot conducteur 13 relie l'extrémité (drain ou source) du transistor 2 à la plaque conductrice 1. Le condensateur 4 (préféré bien qu'optionnel) est constitué de la superposition d'une portion de la plaque d'électrode 1 et d'une ligne conductrice de potentiel fixe, par exemple la masse GND, s'étendant dans la direction des rangées.

La figure 2B est une vue en coupe selon le plan BB de la figure 2A dans laquelle on peut voir du côté inférieur une partie de la plaque support, par exemple une plaque de verre 15. Sur la plaque 15, une section de la ligne conductrice SEL et une section de la plaque d'électrode 1 sont visibles. Au-dessus de la plaque 15 est disposée une plaque supérieure 17 dont la paroi interne est revêtue au moins partiellement d'une couche conductrice 18 d'électrode supérieure. Entre les deux plaques 15 et 17 est inséré un cristal liquide LC.

Dans la présente description, on ne décrira pas les espaceurs et autres moyens de positionnement mutuel des plaques supérieure et inférieure, pas plus que les étapes de réalisation de filtres colorés au dessus des pixels individuels. En effet, ces moyens et étapes sont bien connus et la présente description est centrée sur la réalisation de la plaque inférieure ou plaque active.

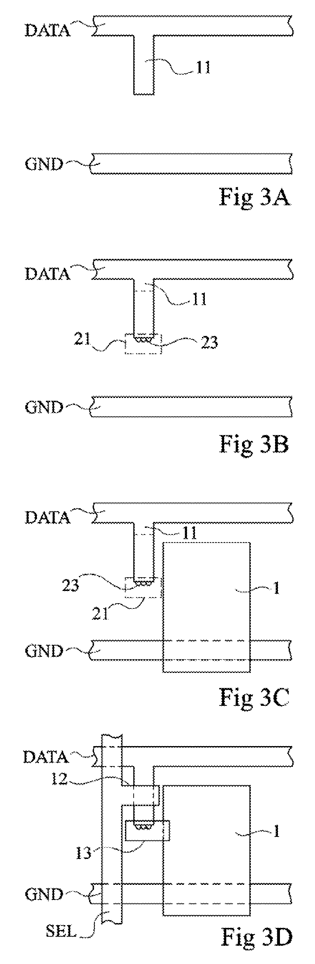

Les figures 3A à 3D sont des vues de dessus illustrant des étapes successives de fabrication d'une cellule de plaque active d'un écran plat selon un mode de réalisation de la présente invention. On comprendra que les structures décrites sont formées sur une plaque support, par exemple une plaque de verre 15 telle que représentée en figure 2B. On notera que la suite d'étapes des figures 3A à 3D ne nécessite que quatre étapes de masquage, chacune de ces figures correspondant à une étape de masquage.

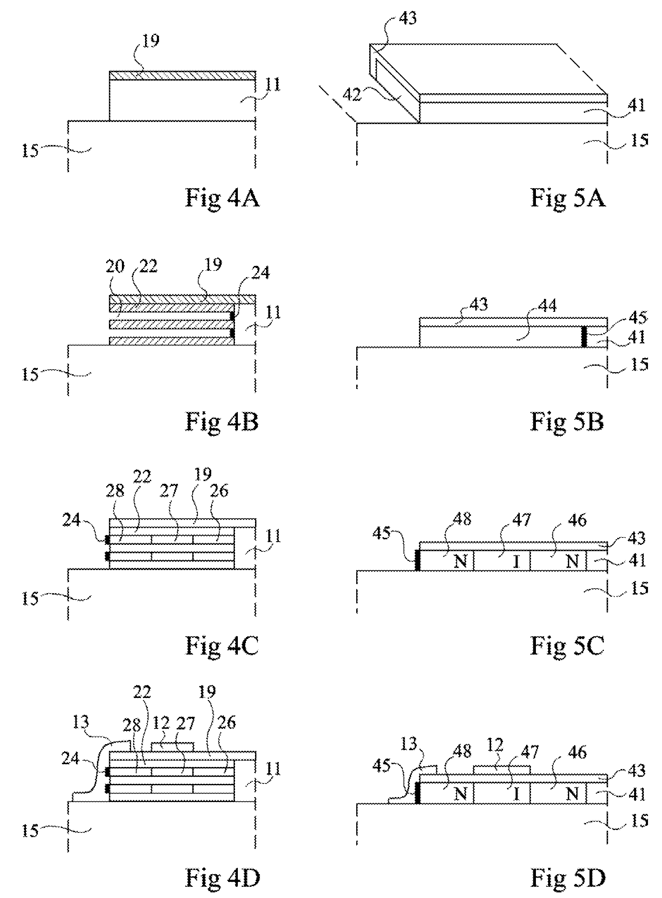

A l'étape illustrée en figure 3A, on dépose et on grave une première couche conductrice, de préférence une couche d'aluminium, ayant par exemple une épaisseur de l'ordre de 100 à 500 nm, et on grave dans cette couche des pistes ayant par exemple une largeur de l'ordre de 2 à quelques dizaines de µm selon la taille de l'écran. On forme ainsi la piste GND et la piste DATA avec son excroissance 11 en direction de la cellule à former. Ensuite, l'ensemble de la structure est revêtu d'une couche isolante 19 (voir figure 4A) ayant notamment une fonction d'encapsulation.

La figure 3A n'est pas tracée à l'échelle. Dans un exemple de réalisation, le pas des cellules dans la direction verticale sera de l'ordre de 100 µm et le pas des cellules dans la direction horizontale sera de l'ordre de 300 µm.

A l'étape illustrée en figure 3B, on ouvre dans la couche isolante 19, au moyen d'un masque dont le contour est désigné par la ligne en pointillés 21, une zone correspondant à l'extrémité de l'excroissance 11 de la piste d'aluminium ou autre métal. Ensuite, par un processus dont deux modes de réalisation améliorés selon la présente invention sont décrits ci-après en relation avec les figures 4A-4D et 5A-5D, on forme dans l'extension 11 un transistor. Selon ce processus, on creuse la piste métallique et on fait croître dans la zone creusée, par un procédé dit VLS (vapeur-liquide-solide), une structure semiconductrice constituant un transistor latéral dont le fond est en contact avec la piste conductrice DATA et dont l'extrémité antérieure 23 apparaît au niveau de l'extrémité de l'excroissance.

A l'étape suivante, illustrée en figure 3C, on dépose une deuxième couche conductrice et on la grave pour laisser en place un motif d'électrode 1. Dans le mode de réalisation préféré, dans lequel il est prévu une piste GND, cette plaque d'électrode 1 recouvre la piste GND pour former avec celle-ci un condensateur. Ainsi, à la fin de l'étape 3C, l'ensemble de la structure est recouvert d'un isolant sauf au niveau de l'ouverture 21 et de la plaque conductrice 1.

A l'étape suivante, illustrée en figure 3D, on dépose une troisième couche conductrice, par exemple de l'aluminium, sur l'ensemble de la structure et on grave cette couche pour former, d'une part, la ligne SEL d'adressage des transistors comprenant une extension 12 s'étendant au-dessus de la zone de canal du transistor MOS et, d'autre part, un plot de contact 13 mettant en contact l'extrémité de drain du transistor et l'électrode 1.

La suite d'étapes décrite en relation avec les figures 3A et 3D l'a été de façon simplifiée pour bien faire ressortir le fait que la structure selon la présente invention peut être fabriquée avec seulement quatre étapes de masquage.

### Modes de réalisation d'un transistor MOS

Les figures 4A et 4D sont des vues en coupe d'étapes successives de fabrication d'un transistor MOS selon un aspect de la présente invention.

Comme l'illustre la figure 4A, la structure est formée sur un substrat isolant, par exemple un substrat de verre 15 sur lequel est formée une piste d'aluminium 11 correspondant par exemple à l'excroissance illustrée en figure 3A. La structure est revêtue d'une couche isolante d'encapsulation 19, par exemple une couche de silice, qui est gravée pour laisser apparente l'extrémité de l'excroissance 11.

Ensuite, on procède à diverses étapes dont le résultat est illustré en figure 4B. Une oxydation anodique de la couche d'aluminium 11 est effectuée dans des conditions telles que décrites par les demandeurs dans la demande de brevet français 2860780. Un avantage de cette oxydation anodique est que les parties de métal apparentes et non soumises à un potentiel adéquat ne sont pas attaquées. Ces couches apparentes sont toutefois de préférence préalablement passivées. En l'occurrence, la piste GND, même si elle n'était pas couverte d'un matériau isolant ne serait pas gravée (on verra que dans certaines variantes de réalisation de l'invention, cette piste GND peut comprendre des parties apparentes ou qu'il peut exister sur la structure des parties métalliques apparentes non recouvertes de silice). L'oxydation anodique transforme l'extrémité de l'excroissance 11 en alumine poreuse 22 comportant des pores 20 essentiellement longitudinaux, c'est-à-dire parallèles au plan principal du substrat 15. Les pores ainsi obtenus ont, selon les conditions d'oxydation, des diamètres de 5 à 300 nm. On notera que l'oxydation anodique peut être suivie d'une gravure effectuée de sorte que le fond des pores soit en contact avec l'aluminium 11 au fond de la zone attaquée. Ensuite, par un procédé d'électrodépôt, on forme au fond des pores, en contact avec la surface d'aluminium restante, des petits plots de catalyseur 24, par exemple en or. Après cela, on procède par la méthode dite VLS à la croissance de fibres d'un matériau semiconducteur à l'intérieur des pores 20. Cette croissance peut être effectuée en trois phases pour obtenir des fibres dont la partie la plus profonde 26 (en contact avec l'aluminium 11) est dopée d'un premier type de conductivité, dont une deuxième partie 27 n'est pas dopée (pratiquement intrinsèque, I) et dont une troisième partie 28 est à nouveau dopée du même type que la partie 26. Un dopage de type N peut par exemple être obtenu en procédant à la croissance des fibres à partir de silane en présence de phosphine ; on obtient alors une structure NIN. Conformément au procédé VLS, on notera que la partie de catalyseur 24 (par exemple de l'or) progresse au fur et à mesure que les fibres croissent et devient apparente à l'extrémité des pores.

Selon une caractéristique importante de l'invention, un transistor est réalisé sans aucune étape de masquage autre que l'étape initiale consistant à dégager l'extrémité de l'excroissance 11 avant de procéder aux divers traitements de gravure et de croissance de fibres semiconductrices. On notera aussi que l'ensemble du canal et des zones de contact du transistor est réalisé dans la même séquence de dépôt.

On a représenté en figure 4D une étape finale correspondant à l'étape décrite précédemment en relation avec la figure 3D, consistant à déposer un métal de grille 12 au-dessus de la zone centrale des fibres et un métal de connexion 13 à l'extrémité des fibres. Ce dernier contact sera particulièrement satisfaisant du fait que cette extrémité est revêtue d'une couche d'or. En outre, les contacts entre l'aluminium et les fibres d'une part, l'or et les fibres d'autre part, est ohmique du fait que l'on a fortement dopé les portions extrêmes des fibres.

La possibilité de faire croître des fibres avec les dopages variables résulte du fait que ces fibres croissent dans des pores. En effet, lors de la croissance de la partie terminale dopée 28, le matériau dopé ne peut pas se déposer sur les parois latérales de la partie intrinsèque 27 qui est "encoquillée". Une telle obtention d'une structure PIP ou NIN (I désignant la zone intrinsèque) n'aurait pas été possible avec des fibres n'ayant pas crû dans une enceinte d'encapsulation.

Selon un autre avantage de la présente invention, le dopage des fibres au cours de leur croissance peut être modifié de façon à avoir un niveau de dopage plus faible à la limite entre chaque région dopée (drain ou source) et la région intrinsèque (canal). On obtient ainsi l'équivalent de structures connues sous l'appellation LDD (Low Drain Doping) dont les avantages sont bien connus dans le cas des transistors MOS classiques. On peut faire varier le dopage des régions dopées entre 10¹⁶ et quelques 10¹⁹, pour obtenir des régions N ou P et N⁺ ou P⁺.

Les figures 5A à 5D illustrent un deuxième mode de réalisation d'un transistor constituant un aspect de la présente invention.

Comme le représente la figure 5A, on part à nouveau d'une excroissance d'une piste métallique 41 déposée sur un substrat 15. Cette portion de piste présente une extrémité ouverte 42 et est par ailleurs encapsulée d'une couche protectrice 43, par exemple de la silice. La piste a par exemple une épaisseur de l'ordre de 100 à 500 nm et une largeur de quelques µm, par exemple 2 à 5 µm.

Dans ce mode de réalisation, comme le représente la figure 5B, le métal 41 est gravé à partir de l'extrémité 42 de façon à former une cavité 44 entourée, à part son extrémité, de la couche protectrice 43. Les inventeurs ont montré qu'avec une telle structure, dont les dimensions ont les ordres de grandeur indiqués ci-dessus, à condition de déposer par électrodépôt au fond de l'ouverture un catalyseur 45, par exemple de l'or, le métal 41 étant par exemple du molybdène, du nickel ou du cuivre, on peut faire croître en partant du fond de la cavité 44 un transistor NIN ou PIP de la même façon que l'on faisait croître des nanofibres dans le mode de réalisation de la figure 4C. Ce résultat est surprenant étant donné que les techniques décrites en relation avec les figures 4A à 4D avaient essentiellement été développées pour former des nanotubes de carbone. Pour les nanotubes de carbone, il n'est pas envisageable d'accroître les dimensions des cavités. Par contre, les inventeurs ont montré que des zones semiconductrices pouvaient croître par le procédé connu VLS dans une cavité de beaucoup plus grandes dimensions telles que celles indiquées ci-dessus.

Comme le représente la figure 5C, on peut ainsi obtenir un transistor comprenant par exemple successivement une portion 46 dopée, par exemple de type N, une portion 47 non dopée (intrinsèque) et une portion d'extrémité 48 dopée du même type de conductivité que la portion 46.

Ensuite, comme l'illustre la figure 5D, on procède, comme dans le cas de la figure 4D, au dépôt d'une métallisation qui est gravée pour former une grille 12 et un contact d'extrémité 13, le contact 13 formant par exemple un contact de drain alors que le métal 41 constitue un contact de source du transistor.

Diverses variantes de réalisation sont possibles pour les transistors décrits ci-dessus et leurs modes de fabrication. Ces variantes apparaîtront à l'homme de l'art. Il pourra par exemple choisir, une fois le transistor formé, d'éliminer partiellement la couche d'encapsulation 19 ou 43 sous la grille 12 pour avoir un isolant de grille plus mince. Des techniques sont connues pour obtenir une telle région amincie sans nécessiter de masque supplémentaire, par exemple en utilisant au-dessus de cette partie de la couche de silice un masque non complètement opaque, ce masque étant par ailleurs destiné à définir la gravure d'autres couches.

### Autres réalisations d'une cellule de plaque active d'écran LCD

Comme on l'a répété plusieurs fois au cours de la présente description, de nombreuses variantes de réalisation des cellules d'une plaque active d'écran plat selon l'invention apparaîtront à l'homme de l'art. Quelques exemples de telles variantes vont être indiqués ci-après.

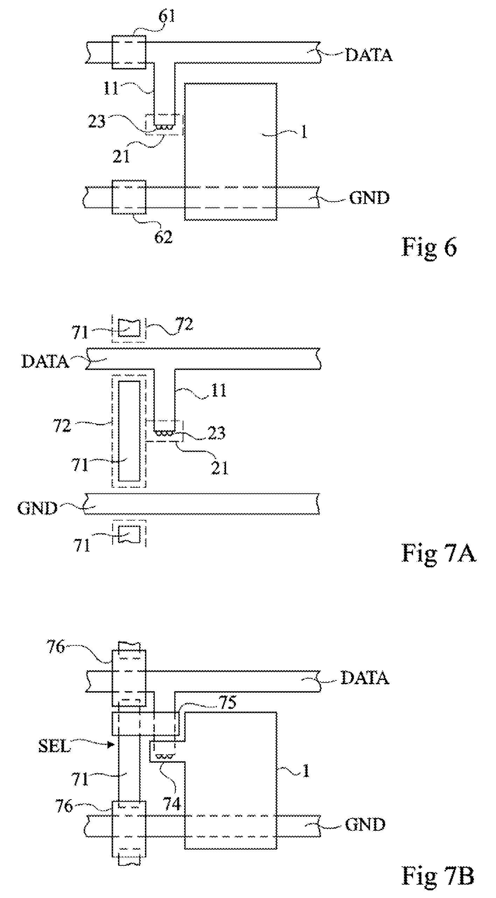

La figure 6 représente une variante du masque utilisé en figure 3C. Rappelons qu'en figure 3C, une couche conductrice avait été déposée uniformément puis gravée pour délimiter une plaque d'électrode 1. Rappelons également qu'à l'étape précédente, la structure était uniformément revêtue d'une couche de silice à l'exception de la région délimitée par le masque 21. Selon la présente variante de l'invention, en même temps que l'on grave l'électrode 1, on laisse en place des portions 61 et 62 de la couche conductrice aux emplacements où la colonne SEL doit croiser les rangées DATA et GND. Ainsi, ces portions 61 et 62 sont disposées au-dessus des lignes DATA et GND avec interposition de silice isolante. Ensuite, en utilisant les régions 1, 61 et 62 comme masques, on peut graver la silice pour l'éliminer complètement ou l'amincir. A l'étape suivante, quand on dépose et qu'on grave la couche destinée à former la colonne SEL et son extension de grille, cette extension de grille peut reposer sur une couche d'isolant, de l'alumine, beaucoup plus mince au-dessus de la zone de canal du transistor. Par contre, on obtient un bon isolement aux croisements entre lignes conductrices grâce à la silice restant en place sous les portions de couche conductrice 61 et 62. Grâce à ce procédé, l'amincissement de l'isolant de grille peut être réalisé sans nécessiter d'étape de masquage supplémentaire.

Les figures 7A et 7B sont des vues de dessus illustrant un deuxième mode de réalisation de la présente invention.

Comme l'illustre la figure 7A, lors de la première gravure, correspondant à ce qui est représenté en figure 3A, en même temps que les lignes DATA et GND et les excroissances 11 de la ligne DATA, on laisse en place des portions de métal 71 aux emplacements où doit se trouver la future ligne SEL, à l'exception des emplacements où cette ligne croise les lignes DATA et GND. Ensuite, au moyen du masque servant à définir l'ouverture 21 (voir figure 3B), on dégage des régions 72 de la surface des métallisations 71. On procède alors à la formation d'un transistor dans l'excroissance 11 de la façon décrite précédemment.

Comme l'illustre la figure 7B, on forme ensuite par gravure d'une même couche conductrice la plaque 1, un contact 74 entre cette plaque et l'extrémité de drain des transistors, une zone de grille 75 et des portions conductrices 76 en pont au-dessus des lignes DATA et GND, destinées à établir la liaison entre les parties 71. On notera que dans ce mode de réalisation, deux étapes seulement de dépôt et de gravure de couches conductrices au lieu de trois sont prévues et qu'il est donc possible de réaliser la structure du pixel avec seulement trois étapes de masquage.

### Réalisation d'une cellule de plaque active d'écran OLED

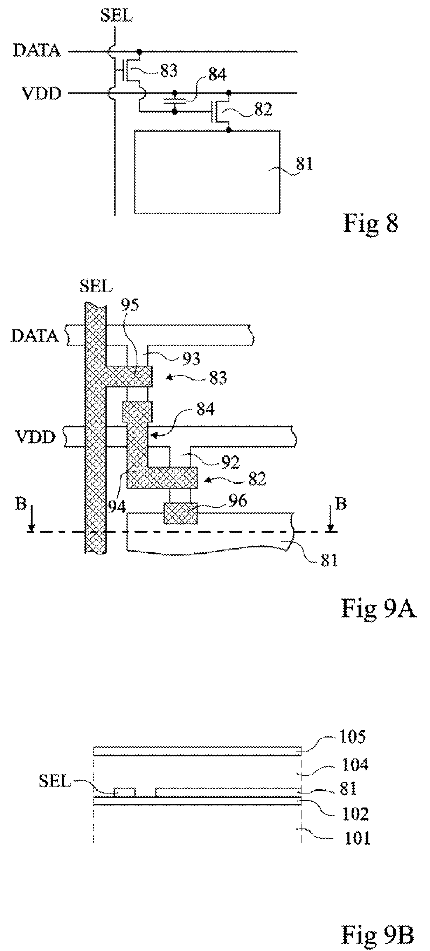

La figure 8 représente partiellement sous forme de circuit un exemple d'un pixel de la plaque active d'un écran de type OLED (de l'anglais Organic Light Emitting Diode). Chaque pixel comprend une plaque d'électrode 81 qui peut être connectée à un potentiel haut (VDD) par l'intermédiaire d'un commutateur 82, couramment un transistor MOS, dont la grille est reliée à une ligne de données (DATA) par l'intermédiaire d'un commutateur 83, couramment un transistor MOS. La grille du transistor 82 est également reliée à la ligne au potentiel VDD par un condensateur 84. La grille du transistor 83 est reliée à une ligne de sélection (SEL). La plaque d'électrode 81 est destinée à constituer une première électrode d'une diode dont l'autre électrode est formée au dessus d'une couche de matériau organique électroluminescent (voir figure 9B).

La figure 9A est une vue de dessus d'un mode de réalisation d'une cellule de plaque active d'écran plat de type OLED selon la présente invention. Cette cellule est formée dans la région de croisement d'une rangée de données DATA et d'une rangée à un potentiel haut, VDD, avec une colonne de sélection SEL, toutes trois constituées de pistes conductrices. La plaque d'électrode est réalisée sous forme d'une plaque conductrice 81, par exemple en un matériau conducteur transparent tel que de l'ITO (oxyde d'indium et d'étain). Le transistor 82 est formé dans une excroissance 92 de la ligne VDD. Le transistor 83 est formé dans une excroissance 93 de la ligne DATA. On comprendra que ces transistors sont formés de l'une des façons décrites précédemment. La grille du transistor 82 est constituée d'une portion d'extrémité d'un tronçon conducteur 94 dont l'autre extrémité est reliée au drain du transistor 83. La grille du transistor 83 est constituée d'une portion 95 de la ligne de sélection SEL s'étendant au-dessus de la partie médiane de l'excroissance 93. Un plot conducteur 96 relie l'extrémité (drain ou source) du transistor 82 à la plaque conductrice 81. Le condensateur 84 est constitué de la partie en superposition du tronçon conducteur 94 et de la ligne conductrice VDD, la surface de la zone de croisement pouvant être ajustée pour optimiser la capacité.

On comprendra à partir de la description précédente de réalisation de cellules de type LCD la façon de réaliser des cellules de type OLED telles que ci-dessus. Notamment, on pourra procéder selon la séquence suivante :
- formation des lignes DATA et VDD avec les excroissances 93 et 92 ;
- formation des transistors MOS 82 et 83 dans les excroissances 92 et 93 ;
- formation des électrodes 81 ;
- formation simultanée de la ligne SEL avec son excroissance 95, du tronçon de ligne 94 et du plot 96.

La figure 9B est une vue en coupe simplifiée selon le plan BB de la figure 9A dans laquelle on peut voir du côté inférieur une partie de la plaque support, par exemple une plaque de verre 101 éventuellement revêtue d'une couche de silice 102. Sur la couche 102, une section de la ligne conductrice SEL et une section de la plaque d'électrode 81 sont visibles. Au-dessus de la plaque 81 sont successivement formées une couche de matériau organique électroluminescent de couleur choisie 104 et une couche conductrice 105.

### Variantes

Dans ce qui précède, on a décrit que la plaque inférieure était une plaque transparente et que les électrodes 1 d'une cellule LCD ou les électrodes 81 d'une cellule OLED étaient transparentes. Ceci correspond au cas d'un écran lisible par transmission. On notera qu'il existe également des écrans lisibles par réflexion. Il n'est alors plus nécessaire que les électrodes 1 ou 81 soient en un matériau transparent et ceci peut simplifier le procédé de fabrication. Notamment, dans certains cas, on pourra alors former l'électrode 1 ou 81 en même temps que l'une des métallisations servant à former les rangées ou les colonnes de la structure. On économise alors une étape de masquage.

Il sera clair pour l'homme de l'art que diverses formes pourront être choisies pour les diverses métallisations et les diverses ouvertures. Notamment, la notion de rangées horizontales et de colonnes verticales est purement arbitraire et d'autres dispositions pourront être choisies par l'homme de métier. De même, la forme de la plaque d'électrode 1 ou 81 et le positionnement des transistors par rapport à cette plaque seront choisis en fonction des préférences du concepteur du panneau d'affichage.

## Revendications

1. Procédé de fabrication de la plaque active d'un écran plat matriciel, dans lequel chaque cellule comprend une plaque d'électrode (1 ; 81) connectée par un transistor (2 ; 82) à une première ligne conductrice, **caractérisé en ce qu'**il comprend les étapes suivantes :
prévoir une excroissance (11 ; 92) enrobée d'isolant de chaque première ligne conductrice au niveau de chaque cellule ;
graver ou rendre poreuse une partie d'extrémité de chaque excroissance ;
faire croître latéralement, par un procédé vapeur-liquide-solide (VLS), une structure semiconductrice PIP ou NIN dans chaque partie d'extrémité gravée ou rendue poreuse ; et
établir un contact à l'extrémité libre de la structure semiconductrice et former une grille au niveau de la partie médiane de la structure semiconductrice.

2. Procédé selon la revendication 1, dans lequel le métal des premières lignes conductrices est de l'aluminium qui est rendu poreux par oxydation anodique au niveau desdites excroissances.

3. Procédé selon la revendication 1, dans lequel le métal des premières lignes conductrices est du nickel ou du molybdène qui est éliminé partiellement sous la partie isolée.

4. Procédé selon la revendication 1, comprenant les étapes suivantes :
déposer et graver sur une plaque de verre une première couche conductrice pour définir les premières lignes conductrices (DATA) comprenant des excroissances (11) au niveau de chaque cellule ;
revêtir la structure d'une couche d'un matériau isolant ;
ouvrir l'extrémité des excroissances et former des transistors dans celles-ci ;
déposer et graver une deuxième couche conductrice pour former les plaques d'électrode (1) ; et
déposer et graver une troisième couche conductrice pour définir des deuxièmes lignes conductrices (SEL), ces deuxièmes lignes comportant des portions (12) recouvrant les zones de canal des transistors, et pour définir une région conductrice (13) connectant une borne principale d'un transistor à une plaque d'électrode.

5. Procédé selon la revendication 4, dans lequel, lors de l'étape de définition des plaques d'électrodes, on prévoit en outre le maintien de régions conductrices (61, 62) au-dessus de parties où les deuxièmes lignes sont amenées à croiser d'autres lignes ou métallisations de la structure.

6. Procédé de fabrication selon la revendication 1, comprenant les étapes suivantes :
définir dans une première couche conductrice des premières lignes (DATA) comprenant des excroissances (11) au niveau de chaque cellule, et des portions (71) de deuxièmes lignes aux emplacements où elles ne croisent pas des premières lignes ;
dégager l'extrémité des premières excroissances et la surface supérieure desdites portions (71) ;
former des transistors dans les excroissances ;
déposer une deuxième couche conductrice, cette deuxième couche étant gravée pour former :
- la plaque d'électrode (1) de chaque cellule,
- une région de grille en contact avec lesdites portions (71), et
- des régions (76) reliant entre elles les portions (71) pour assurer la continuité des deuxièmes lignes.

7. Procédé de fabrication selon la revendication 1, dans lequel une partie de la plaque d'électrode (1) s'étend au-dessus d'une portion d'une troisième ligne conductrice (GND), la ligne conductrice étant une ligne d'aluminium et un diélectrique tel que de l'alumine étant interposé entre la partie de plaque d'électrode et la ligne conductrice.

8. Procédé de fabrication selon la revendication 1, dans lequel deux transistors par cellule sont formés simultanément à partir d'excroissances enrobées d'isolant de diverses lignes conductrices de chaque cellule.

## Patentansprüche

1. Ein Verfahren zum Herstellen einer aktiven Platte eines Matrix Flachbildschirms in welchem jede Zelle eine Elektrodenplatte (1; 81) aufweist, die über einen Transistor (2; 82) mit einer ersten Anschlussleitung verbunden ist, **dadurch gekennzeichnet, dass** das Verfahren die folgenden Schritte aufweist:
Bereitstellen eines Auswuchses bzw. Überschusses (11; 92) auf der Höhe Zelle von jeder ersten Anschlussleitung, beschichtet mit einem Isolator;
Ätzen oder porös machen eines Endteils des Überschusses;
seitliches wachsen lassen, mittels eines VLS Verfahrens, einer PIP oder NIN Halbleiterstruktur in jedem Endteil, der geätzt oder porös gemacht wurde; und
Einrichten eines Kontaktes an dem freien Ende der Halbleiterstruktur und Ausbilden eines Gates auf der Höhe des mittleren Teils der Halbleiterstruktur.

2. Das Verfahren nach Anspruch 1, in dem das Metall der ersten leitenden Verbindung Aluminium ist welches durch Anodisierung auf der Höhe des Überschusses porös gemacht wurde.

3. Das Verfahren nach Anspruch 1, in dem das Metall der ersten leitenden Verbindung Nickel oder Molybdän ist, welches teilweise unter dem isolierten Teil entfernt wurde.

4. Das Verfahren nach Anspruch 1, wobei das Verfahren ferner die folgenden Schritte aufweist:
Ablagern und Ätzen einer ersten leitenden Schicht auf einer Glasplatte, um die ersten leitenden Verbindungen (DATA) zu definieren, die Überschüsse (11) auf der Höhe jeder Zelle aufweisen;
Beschichten der Struktur mit einer Schicht von isolierendem Material;
Öffnen der Enden der Überschüsse und Ausbilden eines Transistor darin;
Ablagern und Ätzen einer zweiten leitenden Schicht, um die Elektrodenplatte (1) auszubilden; und
Ablagern und Ätzen einer dritten leitenden Schicht, um zweite leitende Verbindungen (SEL) zu definieren, wobei die zweiten Verbindungen Teile (12) aufweisen, die die Kanalbereiche der Transistoren abdecken, und zum Definieren eines leitenden Bereichs (13), der einen Hauptanschluss eines Transistors mit einer Elektrodenplatte verbindet.

5. Das Verfahren nach Anspruch 4, in dem der Elektrodenplatten Definitionsschritt ferner das Aufrechterhalten leitender Bereiche (61, 62) über Teilen, in denen die zweiten leitenden Verbindungen die anderen leitenden Verbindungen oder Metallisierungen der Struktur kreuzen, ferner vorgesehen ist.

6. Das Herstellungsverfahren nach Anspruch 1, wobei das Verfahren ferner die folgenden Schritte aufweist:
Definieren, in einer ersten leitenden Schicht, von ersten Verbindung (DATA), die Auswüchse bzw. Überschüsse (11) auf der Höhe jeder Zelle aufweisen, und von Teilen (71) von zweiten Verbindungen an den Orten, an denen diese keine ersten Verbindungen kreuzen;
Öffnen der Enden der ersten Überschüsse und der Oberseite von den Teilen (71);
Ausbildung von Transistoren in den Überschüssen;
Ablagern einer zweiten leitenden Schicht, wobei die zweite Schicht geätzt wird um Folgendes auszubilden:
die Elektronenplatte (1) von jeder Zelle,
einen Gate Bereich, der in Kontakt ist mit den Teilen (71), und
Bereiche (76), die die Teile (71) untereinander verbinden, um die Kontinuität der zweiten Verbindungen sicherzustellen.

7. Das Verfahren zur Herstellung nach Anspruch 1, in welchem sich ein Teil der Elektrodenplatte (1) über einen Teil einer dritten leitenden Verbindung (GND) erstreckt, wobei die leitende Verbindung eine Aluminiumleitung ist, und wobei ein Dielektrikum, wie zum Beispiel Aluminiumoxid, zwischen den Elektrodenplattenteil und die leitende Verbindung eingebracht ist.

8. Das Verfahren zur Herstellung nach Anspruch 1, in dem zwei Transistoren pro Zelle gleichzeitig von Überschüssen ausgebildet werden, die mit Isolatoren von verschiedenen leitenden Verbindungen von jeder Zelle beschichtet sind.

## Claims

1. A method for manufacturing the active plate of a flat matrix display screen, in which each cell comprises an electrode plate (1; 81) connected by a transistor (2; 82) to a first conductive line, **characterized in that** it comprises the steps of:
providing an outgrowth (11; 92) coated with an insulator of each first conductive line at the level of each cell;
etching or making porous an end portion of each outgrowth;
laterally growing, by a VLS method, a PIP or NIN semiconductor structure in each end portion which has been etched or made porous; and
establishing a contact at the free end of the semiconductor structure and forming a gate at the level of the median portion of the semiconductor structure.

2. The method of claim 1, in which the metal of the first conductive lines is aluminum which is made porous by anodic oxidation at the level of said outgrowths.

3. The method of claim 1, in which the metal of the first conductive lines is nickel or molybdenum which is partially eliminated under the insulated portion.

4. The method of claim 1, comprising the steps of:
depositing and etching on a glass plate a first conductive layer to define the first conductive lines (DATA) comprising outgrowths (11) at the level of each cell;
coating the structure with a layer of an insulating material;
opening the end of the outgrowths and forming transistors therein;
depositing and etching a second conductive layer to form the electrode plates (1); and
depositing and etching a third conductive layer to define second conductive lines (SEL), the second lines comprising portions (12) covering the channel areas of the transistors, and to define a conductive region (13) connecting a main terminal of a transistor to an electrode plate.

5. The method of claim 4, in which in the electrode plate definition step, the maintaining of conductive regions (61, 62) above portions where the second lines cross other lines or metallizations of the structure is further provided.

6. The manufacturing method of claim 1, comprising the steps of:
defining in a first conductive layer first lines (DATA) comprising outgrowths (11) at the level of each cell, and portions (71) of second lines at the locations where they do not cross first lines;
opening the end of the first outgrowths and the upper surface from said portions (71);
forming transistors in the outgrowths;
depositing a second conductive layer, this second layer being etched to form:
- the electrode plate (1) of each cell,
- a gate region in contact with said portions (71), and
- regions (76) interconnecting the portions (71) to ensure the continuity of the second lines.

7. The manufacturing method of claim 1, in which a portion of the electrode plate (1) extends above a portion of a third conductive line (GND), the conductive line being an aluminum line and a dielectric such as alumina being interposed between the electrode plate portion and the conductive line.

8. The manufacturing method of claim 1, in which two transistors per cell are simultaneously formed from outgrowths coated with insulator of various conductive lines of each cell.
